# EUROPÄISCHE PATENTSCHRIFT

(11) **EP 1 256 169 B1**
(45) Veröffentlichungstag und Bekanntmachung des Hinweises auf die Patenterteilung: **10.09.2003**
(21) Anmeldenummer: 01913645.6
(22) Anmeldetag: 14.02.2001
(51) Int. Cl.: H03K 3/00

(54) **SCHALTUNGSANORDNUNG ZUR MITTELS EINER STEUEREINHEIT GESTEUERTEN ENTLADUNG EINER AUF EINE HOHE SPANNUNG AUFGELADENEN KAPAZITÄT AUF EINE NIEDERE SPANNUNG**
CIRCUIT CONFIGURATION FOR THE DISCHARGE CONTROLLED BY MEANS OF A CONTROL UNIT OF A CAPACITOR FROM A HIGH VOLTAGE TO A LOW VOLTAGE
CIRCUIT DE DECHARGE COMMANDEE PAR UNE UNITE DE COMMANDE D'UN CONDENSATEUR D'UNE HAUTE TENSION VERS UNE BASSE TENSION

(30) Priorität: 15.02.2000 DE 10006517
(43) Veröffentlichungstag der Anmeldung: 13.11.2002
(73) Patentinhaber: Infineon Technologies AG, 81669 München (DE)
(72) Erfinder: BLOCH, Martin, 82194 Gröbenzell (DE); VEGA ORDONEZ, Esther, 80337 München (DE)
(74) Vertreter: Repkow, Ines, Dr. Dipl.-Ing.
(86) Internationale Anmeldenummer: DE0100569
(87) Internationale Veröffentlichungsnummer: WO01061851

(56) Entgegenhaltungen:
- DE-A- 19 816 446
- US-A- 5 350 951
- PATENT ABSTRACTS OF JAPAN vol. 011, no. 342 (P-635), 10. November 1987 (1987-11-10) & JP 62 124700 A (MITSUBISHI ELECTRIC CORP), 5. Juni 1987 (1987-06-05)

## Beschreibung

Die Erfindung betrifft eine Schaltungsanordnung zur mittels einer Steuereinheit gesteuerten Entladung einer auf eine hohe Spannung aufgeladenen ersten Kapazität auf eine niedere Spannung. bei der die eine Elektrode der ersten Kapazität auf Bezugspotential liegt, während deren andere Elektrode über die Streckenelektroden eines ersten Transistors mit der einen Elektrode einer zweiten Kapazität verbunden ist, deren andere andere Elektrode auf Bezugspotential liegt, und bei der parallel zur zweiten Kapazität eine Spannungsquelle mit ihrem Innenwiderstand liegt, wobei der gemeinsame knoten der Source-Elektrode des ersten Feldeffekttransistors und der ersten Kapazität über eine Reihenschaltung aus der Strecke eines zweiten Feldeffekttransistors und eines dritten Feldeffekttransistors auf Bezugspotential liegt. Eine solche Schattungsanordnung gemäß Oberbegriff des Anspruchs 1 ist aus der DE-A-19 816 446 bekannt.

In modernen Halbleiterschaltungen werden sowohl eine höhere als auch eine tiefere als die normalerweise zur Verfügung stehende Versorgungsspannung benötigt. In Halbleiterschaltungen, die Speicher wie zum Beispiel Flash, EEPROM, DRAM oder FRAM, enthalten, sind hohe Spannungen erforderlich, während gleichzeitig Designs in der Größenordnung von 0,25 µm bis 0,18 µm niedere Versorgungsspannungen von beispielsweise 2,5 V, 1,8 V bis zu 1 V erfordern. Derart niedere Versorgungsspannungen sind auch erforderlich, um den Energieverbrauch, insbesondere kontaktloser Systeme, wie zum Beispiel Mobiltelefone, Chipcards, Smartcards oder in der Medizintechnik, möglichst gering zu halten.

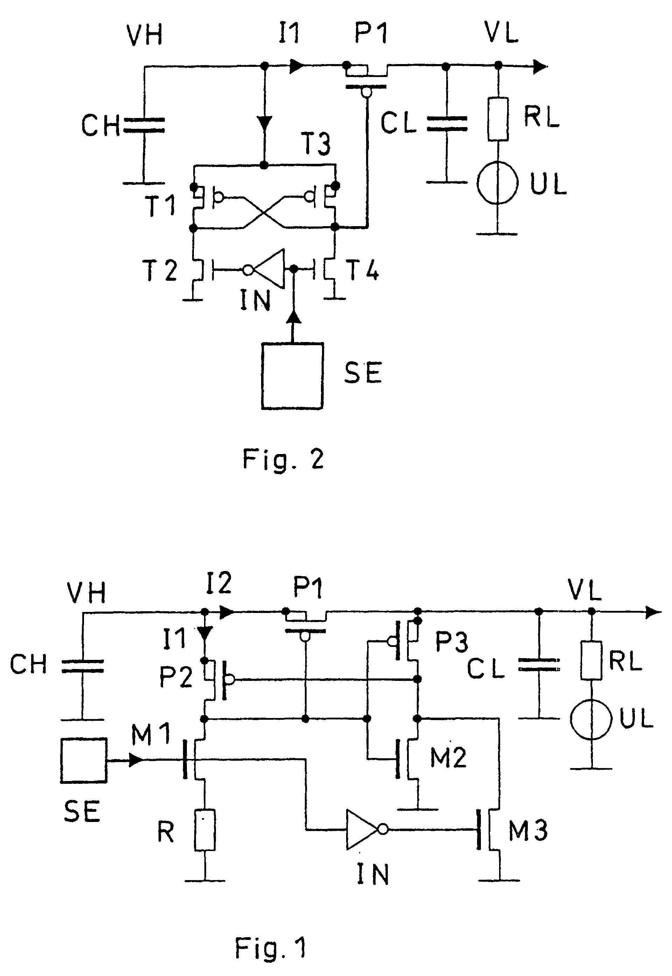

In der Figur 2 ist eine bekannte Schaltungsanordnung zur mittels einer Steuereinheit gesteuerten Entladung einer auf eine hohe Spannung aufgeladenen ersten Kapazität auf eine niedere Spannung gezeigt, die in Halbleiterschaltungen eingesetzt wird.

In dieser Schaltung liegt die eine Elektrode der ersten Kapazität CH auf Bezugspotential, während deren andere Elektrode mit der Source-Elektrode eines PMOS-Feldeffekttransistors P1 verbunden ist. Die Drain-Elektrode des PMOS-Feldeffekttransistors P1 liegt über eine Kapazität CL auf Bezugspotential, zu der eine Spannungsquelle UL mit ihrem Innenwiderstand RL parallel geschaltet ist. Die Source-Elektrode des PMOS-Transistors P1 liegt über eine Reihenschaltung aus der Source-Drain-Strecke eines PMOS-Transistors T1 und eines Feldeffekttransistors T2 auf Bezugspotential. Parallel zu der Reihenschaltung aus den Source-Drain-Strecken der beiden Transistoren T1 und T2 liegt eine Reihenschaltung aus der Source-Drain-Strecke eines PMOS-Transistors T3 und eines Feldeffekttransistors T4. Die Gate-Elektrode des PMOS-Transistors T1 ist mit dem gemeinsamen Knoten der beiden Transistoren T3 und T4 sowie mit der Gate-Elektrode des PMOS-Transistors T1 verbunden. Die Gate-Elektrode des PMOS-Feldeffekttransistors T3 ist mit dem gemeinsamen Knoten der beiden Transistoren T1 und T2 verbunden. Die Gate-Elektrode des Transistors T4 ist über einen Inverter IN mit der Gate-Elektrode des Transistors T2 verbunden. Der Ausgang einer Steuereinheit SE ist mit der Gate-Elektrode des Transistors T4 und somit mit dem Eingang des Inverters IN verbunden.

Die Transistoren T1 bis T4 sowie der Inverter IN stellen einen Pegelübersetzer dar.

Es wird nun die Funktion der in der Fig. 2 abgebildeten Schaltungsanordnung erläutert.

Die Kapazität CH ist auf die hohe Spannung VH geladen. Die Steuereinheit SE gibt an ihrem Ausgang eine logische Null an den Pegelübersetzer ab, der den PMOS-Feldeffekttransistor P1 sperrt. Wenn die Steuereinheit SE eine logische 1 an den Pegelübersetzer abgibt, wird der PMOS-Transistor P1 leitend, so dass die beiden Kapazitäten CH und CL parallel geschaltet sind. Von der Kapazität CH fließt nun ein Entladestrom I1 durch den PMOS-Feldeffekttransistor P1 zur Kapazität CL. Dieser Entladevorgang verläuft nach einer 1/e^{t}-Funktion, so dass theoretisch die Spannung an der Kapazität CH für t → 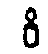 auf die Spannung VL an der Kapazität CL sinkt. Aus diesem Grund dauert der Entladevorgang verhältnismäßig lange. Weil es sich. bei der Spannungsquelle UL nicht um eine ideale, sondern um eine reale Spannungsquelle handelt, wird die Spannung an der Kapazität CL um einen kleinen Wert über der Spannung VL liegen und erst gegen Ende des Entladevorganges auf den Spannungswert der Spannungsquelle UL absinken. Weil das Potential an der Gate-Elektrode des PMOS-Transistors P1 schnell gegen Masse entladen wird, ist dieser Transistor P1 einem großen Verschleiß ausgesetzt, der sowohl seine Lebensdauer als auch seine Zuverlässigkeit erheblich reduziert.

Damit die Kapazität CH möglichst genau auf die Spannung VL entladen wird, ist die Kapazität CL möglichst groß, der Innenwiderstand RL der Spannungsquelle UL dagegen möglichst klein zu wählen. Hierzu ist eine genaue Kenntnis der Kennlinien der Kapazität CH und des Leitwiderstandes des PMOS-Transistors P1 erforderlich. Je größer der Innenwiderstand RL der Spannungsquelle UL ist, desto größer ist zur Kompensation die Kapazität CL zu wählen. Nach dem Entladevorgang kann die Spannung VL an der Kapazität CL noch so groß sein, dass nachgeschaltete Schaltungsanordnungen mit CMOS-Feldeffekttransistoren zerstört werden können. Dies ist zum Beispiel der Fall, wenn eine Versorgungsspannung von 16 V für ein EEPROM und eine Versorgungsspannung von 1,5 V für eine CMOS-Schaltungsanordnung benötigt werden.

Es ist daher Aufgabe der Erfindung, eine Schaltungsanordnung gemäß Oberbegriff des Anspruchs 1 so zu gestalten, dass eine schnelle Entladung auf genau die geforderte niedere Spannung erzielt wird.

Die Erfindung löst diese Aufgabe gemäß den im Anspruch 1 angegebenen Merkmalen dadurch, dass der gemeinsame Knoten der Drain-Elektrode des ersten Feldeffekttransistors, der zweiten Kapazität und der Spannungsquelle über eine Reihenschaltung aus der Strecke eines vierten Feldeffekttransistors und eines fünften Feldeffekttransistors auf Bezugspotential liegt, dass die Gate-Elektroden des ersten, des vierten und des fünften Feldeffekttransistors sowie der gemeinsame Knoten des zweiten und dritten Feldeffekttransistors miteinander verbunden sind, dass der gemeinsame Knoten des vierten und fünften Feldeffekttransistors mit der Gate-Elektrode des zweiten Feldeffekttransistors verbunden ist und über die Strecke eines sechsten Feldeffekttransistors auf Bezugspotential liegt und dass der Steuerausgang der Steuereinheit mit der Gate-Elektrode des dritten Feldeffekttransistors und mit dem Eingang eines Inverters verbunden ist, dessen Ausgang mit der Gate-Elektrode des sechsten Feldeffekttransistors verbunden ist.

Die Entladung der ersten Kapazität von der hohen auf die niedere Spannung erfolgt schnell, genau und nahezu linear.

Die Erfindung wird anhand der Figuren näher beschrieben und erläutert. In der Zeichnung zeigen:
- Fig. 1: ein Ausführungsbeispiel der Erfindung,
- Fig. 2: eine Schaltungsanordnung gemäß dem Stand der Technik,
- Fig. 3: ein Entladediagramm der bekannten Schaltungsanordnung aus Fig. 2 und
- Fig. 4: ein Entladediagramm der Erfindung.

Die in der Fig. 1 abgebildete bekannte Schaltungsanordnung wurde eingangs bereits beschrieben und erläutert.

Das in der Fig. 1 gezeigte Ausführungsbeispiel der Erfindung hat folgenden Aufbau:

Die eine Elektrode einer Kapazität CH liegt auf Bezugspotential. während deren andere Elektrode mit der Source-Elektrode eines Feldeffekttransistors P2 und eines Feldeffekttransistors P1 verbunden ist, dessen Drain-Elektrode über eine Kapazität CL auf Bezugspotential liegt. Parallel zur Kapazität CL liegt eine Spannungsquelle UL mit ihrem Innenwiderstand RL. Die Drain-Elektrode des Feldeffekttransistors P2 liegt über eine Reihenschaltung aus der Strecke eines Feldeffekttransistors M1 und eines Schutzwiderstandes R auf Bezugspotential. Der gemeinsame Knoten des Feldeffekttransistors P1 und der Kapazität CL liegt über eine Reihenschaltung aus der Strecke eines Feldeffekttransistors P3 und eines Feldeffekttransistors M2 auf Bezugspotential. Die miteinander verbundenen Gate-Elektroden der Feldeffekttransistoren P1, P3 und M2 sind an den gemeinsamen Knoten der beiden Feldeffekttransistoren P2 und M1 angeschlossen. Der gemeinsame Knoten der Feldeffekttransistoren P3 und M2 ist mit der Gate-Elektrode des Feldeffekttransistors P2 verbunden und liegt über die Strecke eines weiteren Feldeffekttransistors M3 auf Bezugspotential. Der Steuerausgang der Steuereinheit SE ist mit der Gate-Elektrode des Feldeffekttransistors M1 und mit dem Eingang eines Inverters IN verbunden, dessen Ausgang mit der Gate-Elektrode des Feldeffekttransistors M3 verbunden ist.

Neben dem ersten Inverter IN bilden die Feldeffekttransistoren P3 und M2 einen zweiten Inverter.

Es wird nun der Entladevorgang des in der Fig. 1 dargestellten erfindungsgemäßen Ausführungsbeispieles erläutert.

Vor Beginn des Entladevorgangs ist die Kapazität CH auf die höhere Spannung VH geladen. Die Steuereinheit SE gibt an ihrem Steuerausgang eine logische Null an die Gate-Elektrode des Feldeffekttransistors M1 und den Eingang des Inverters IN ab. Wegen der logischen Eins am Ausgang des Inverters IN ist der Feldeffekttransistor M3 durchgeschaltet, so dass an der Gate-Elektrode des Feldeffekttransistors P2 Bezugspotential anliegt. Weil der Feldeffekttransistor P2 deshalb die Gate-Elektrode des Feldeffekttransisitors P1 auf das Potential VH zieht, ist der Feldeffekttransistor P1 gesperrt. Die Kapazität CL ist auf die niedere Spannung VL geladen. Der zweite aus den Feldeffekttransistoren P3 und M2 gebildete Inverter liefert an seinem Ausgang eine logische 0, weil der Feldeffekttransistor M2 stark leitet, während der Feldeffekttransistor P3 gesperrt ist. Der Schutzwiderstand R begrenzt den Strom durch die Strecke des Feldeffekttransistors M1 und schützt ihn daher vor Beschädigung oder gar Zerstörung durch zu hohe Ströme.

Zur Entladung der Kapazität CH von der hohen Spannung VH auf die niedere Spannung VL gibt die Steuereinheit SE an ihrem Ausgang eine logische Eins an die Gate-Elektrode des Feldeffekttransistors M1 und an den Eingang des Inverters IN ab. Weil dadurch die beiden Feldeffekttransistoren P2 und M1 leitend sind, fließt ein Entladestrom I1 von der Kapazität CH über die Strecken der beiden Feldeffekttransistoren P2 und M1 sowie über den Schutzwiderstand R nach Bezugspotential, wodurch die Gate-Elektrode des Feldeffekttransistors P1 auf Bezugspotential gezogen wird. Während dieser Phase wird der größte Teil der auf der Kapazität CH gespeicherten Ladung über Bezugspotential entladen. Sobald die Spannung VH an der Kapazität CH auf den Wert VL und somit auch das Potential an der Gate-Elektrode des Feldeffekttransistors P1 gesunken ist, beginnt dieser Feldeffekttransistor P3 langsam zu leiten, während der Feldeffekttransistor M2 langsam sperrt. Das Potential am Ausgang des aus den Feldeffekttransistoren P3 und M2 gebildeten Inverters wird daher positiv, so dass der Feldeffekttransistor P2 langsam in den gesperrten Zustand übergeht. Bei gesperrtem Feldeffekttransistor P2 wird die Gate-Elektrode des Feldeffekttransistors P1 schnell gegen Bezugspotential entladen, weil der Widerstand des Feldeffekttransistors M1 nun kleiner ist als der des Feldeffekttransistors P2. Die Feldeffekttransistoren P2, P3 und M2 legen daher die Gate-Elektrode des Feldeffekttransistors P1 schlagartig auf Bezugspotential, wodurch der Entladevorgang über die Strecken des Feldeffekttransistors P2 und M1 sowie des Schutzwiderstandes R angehalten wird. Gleichzeitig wird der Feldeffekttransistor P1 leitend, der die Kapazitäten CH und CL parallel schaltet, so dass beide Kapazitäten nunmehr auf die niedere Spannung VL geladen sind. Um die Kapazität CH auf diesem Potential zu halten, fließt der verhältnismäßig kleine Strom 12 zwischen den beiden Kapazitäten CH und CL. Sobald das Potential an der Kapazität CH auf den geforderten niederen Wert VL abgesunken ist, wird der Entladepfad unterbrochen und gleichzeitig ein Haltepfad über die Strecke des Feldeffekttransistors P1 aktiviert.

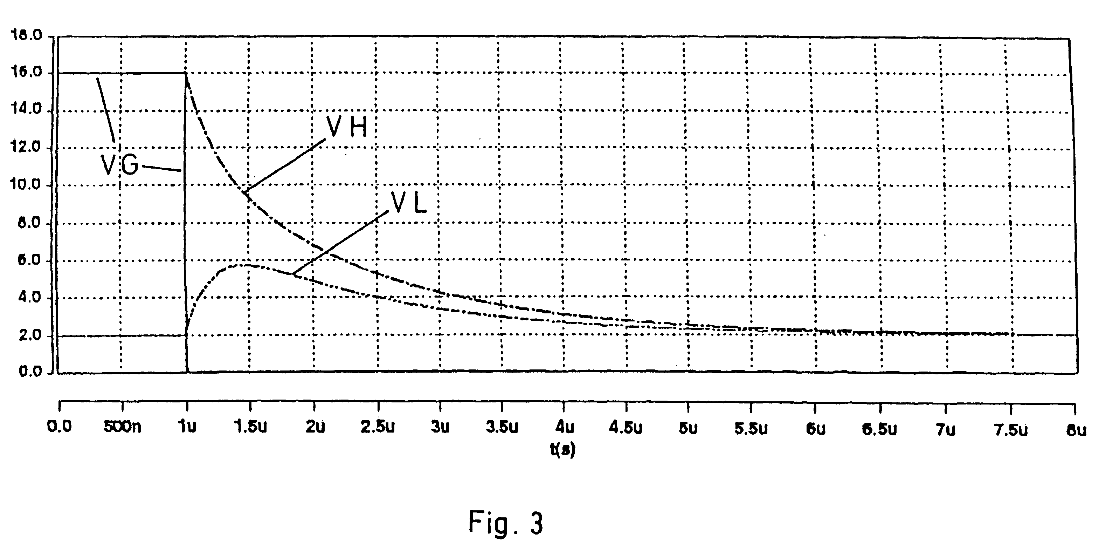

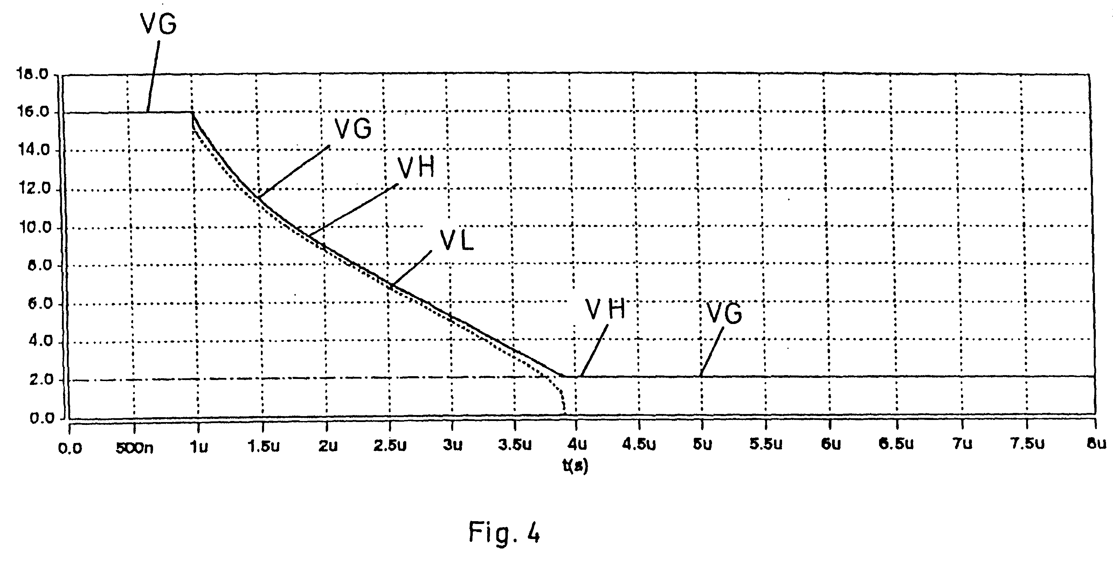

In den Fig. 3 und 4 ist der zeitliche Verlauf des Potentials VG an der Gate-Elektrode des PMOS-Feldeffekttransistors P1, des Potentials VH an der Kapazität CH und des Potentials VL an der Kapazität CL dargestellt.

In der Fig. 4 ist das Entladediagramm der bekannten in Fig. 2 abgebildeten Schaltungsanordnung dargestellt. Der Entladevorgang erfolgt nach einer e-Funktion. Deutlich ist die zu Beginn des Entladevorgangs an der Kapazität CL auftretende Spannungsüberhöhung zu erkennen.

Dagegen zeigt das in Fig. 3 dargestellte Entladediagramm der Erfindung einen fast linearen Verlauf ohne jegliche Spannungsüberhöhung.
Die wesentlichen Vorteile der Erfindung sind darin zu sehen, dass ein schneller und fast linearer Entladevorgang erzielt wird und dass keine überhöhten Spannungen mehr auftreten, wodurch die Zuverlässigkeit und Lebensdauer nachgeschalteter Bauelemente, insbesondere von CMOS-Transistoren, beträchtlich erhöht werden.

Der Schutzwiderstand R ist nicht unbedingt erforderlich, erhöht aber die Zuverlässigkeit und Lebensdauer der Feldeffekttransistoren P2 und M1.

Vorzugsweise sind für die Feldeffekttransistoren P1, P2 und P3 PMOS-Feldeffekttransistoren vorgesehen, während für die restlichen Feldeffekttransistoren M1 M2 und M3 NMOS-Feldeffekttransistoren vorzuziehen sind.

Die Erfindung ist allgemein zur schnellen und sicheren Entladung einer Kapazität von einer hohen Spannung auf eine niedere Spannung geeignet. Der Entladevorgang erfolgt nahezu linear; zu keinem Zeitpunkt während des Entladevorgangs treten Überspannungen auf. Die Erfindung ist daher insbesondere für Halbleiterschaltungen geeignet, in denen sowohl beispielsweise wegen Speicher bestimmter Bauart hohe Spannungen als auch zur Energieeinsparung niedere Spannungen benötigt werden.

### Bezugszeichenliste:

- CH: Kapazität
- CL: Kapazität
- IN: Inverter
- I1: Entladestrom
- I2: Haltestrom
- M1: Feldeffekttransistor
- M2: Feldeffekttransistor
- M3: Feldeffekttransistor
- P1: PMOS-Feldeffekttransistor
- P2: PMOS-Feldeffekttransistor
- P3: PMOS-Feldeffekttransistor
- R: Schutzwiderstand
- RL: Innenwiderstand der Spannungsquelle
- UL: Spannungsquelle
- VH: hohe Spannung
- VL: niedere Spannung

## Patentansprüche

1. Schaltungsanordnung zur mittels einer Steuereinheit (SE) gesteuerten Entladung einer auf eine hohe Spannung (VH) aufgeladenen ersten Kapazität (CH) auf eine niedere Spannung (VL), bei der die eine Elektrode der ersten Kapazität (CH) auf Bezugspotential liegt, während deren andere Elektrode über die Strecke eines ersten Feldeffekttransistors (P1) mit der einen Elektrode einer zweiten Kapazität (CL) verbunden ist, deren andere Elektrode auf Bezugspotential liegt, und bei der parallel zur zweiten Kapazität (CL) eine Spannungsquelle (UL) mit ihrem Innenwiderstand (RL) liegt, wobei der gemeinsame Knoten der Source-Elektrode des ersten Feldeffekttransistors (P1) und der ersten Kapazität (CH) über eine Reihenschaltung aus der Strecke eines zweiten Feldeffekttransistors (P2) und eines dritten Feldeffekttransistors (M1) auf Bezugspotential liegt, **dadurch gekennzeichnet, dass** der gemeinsame Knoten der Drain-Elektrode des ersten Feldeffekttransistors (P1) der zweiten Kapazität (CL) und der Spannungsquelle (UL) über eine Reihenschaltung aus der Strecke eines vierten Feldeffekttransistors (P3) und eines fünften Feldeffekttransistors (M2) auf Bezugspotential liegt, dass die Gate-Elektroden des ersten, vierten und fünften Feldeffekttransistors (P1, P3, M2) sowie der gemeinsame Knoten des zweiten und des dritten Feldeffekttransistors (P2, M1 miteinander verbunden sind, dass der gemeinsame Knoten des vierten und fünften Feldeffekttransistors (P3, M3) mit der Gate-Elektrode des zweiten Feldeffekttransistors (P2) verbunden ist und über die Strecke eines sechsten Feldeffekttransistors (M3) auf Bezugspotential liegt und dass der Steuerausgang der Steuereinheit (SE) mit der Gate-Elektrode des dritten Feldeffekttransistors (M1) und mit dem Eingang eines Inverters (IN) verbunden ist, dessen Ausgang mit der Gate-Elektrode des sechsten Feldeffekttransistors (M3) verbunden ist.

2. Schaltungsanordnung nach Anspruch 1,
**dadurch gekennzeichnet, dass** zwischen dem dritten Feldeffekttransistor (M1) und Bezugspotential ein Schutzwiderstand (R) liegt.

3. Schaltungsanordnung nach Anspruch 1 oder 2,
**dadurch gekennzeichnet, dass** für den ersten, zweiten und vierten Feldeffekttransistor (P1, P2, P3) PMOS-Feldeffekttransistoren vorgesehen sind.

4. Schaltungsanordnung nach Anspruch 1, 2 oder 3,
**dadurch gekennzeichnet, dass** für den dritten, fünften und sechsten Feldeffekttransistor (M1, M2, M3) NMOS-Feldeffekttransistoren vorgesehen sind.

## Claims

1. Circuit arrangement for discharging a first capacitor (CH) which has been charged to a high voltage (VH) to a low voltage (VL) under the control of a control unit (SE), in which one electrode of the first capacitor (CH) is connected to reference-ground potential while the other electrode thereof is connected via the path of a first field effect transistor (P1) to one electrode of a second capacitor (CL) whose other electrode is connected to reference-ground potential, and in which a voltage source (UL) with its internal resistance (RL) is arranged in parallel with the second capacitor (CL), the common node for the source electrode of the first field effect transistor (P1) and for the first capacitor (CH) being connected to reference-ground potential via a series circuit comprising the path of a second field effect transistor (P2) and that of a third field effect transistor (M1) **characterized in that** the common node for the drain electrode of the first field effect transistor (P1), for the second capacitor (CL) and for the voltage source (UL) is connected to reference-ground potential via a series circuit comprising the path of a fourth field effect transistor (P3) and that of a fifth field effect transistor (M2), **in that** the gate electrodes of the first, fourth and fifth field effect transistors (P1, P3, M2) and the common node for the second and third field effect transistors (P2, M1) are connected to one another, **in that** the common node for the fourth and fifth field effect transistors (P3, M3) is connected to the gate electrode of the second field effect transistor (P2) and is connected to reference-ground potential via the path of a sixth field effect transistor (M3), and **in that** the control output of the control unit (SE) is connected to the gate electrode of the third field effect transistor (M1) and to the input of an inverter (IN) whose output is connected to the gate electrode of the sixth field effect transistor (M3).

2. Circuit arrangement according to Claim 1,
**characterized in that** a protective resistor (R) is arranged between the third field effect transistor (M1) and reference-ground potential.

3. Circuit arrangement according to Claim 1 or 2,
**characterized in that** PMOS field effect transistors are provided for the first, second and fourth field effect transistors (P1, P2, P3).

4. Circuit arrangement according to Claim 1, 2 or 3,
**characterized in that** NMOS field effect transistors are provided for the third, fifth and sixth field effect transistors (M1 M2, M3).

## Revendications

1. Agencement de circuit pour décharger jusqu'à une basse tension (VL) une première capacité (CH) chargée à une haute tension (VH), sous la commande d'une unité de commande (SE), dans lequel l'une des électrodes de la première capacité (CH) est placée à un potentiel de référence, son autre électrode étant reliée par l'intermédiaire de la section d'un premier transistor à effet de champ (P1) à l'une des électrodes d'une deuxième capacité (CL) dont l'autre électrode est raccordée au potentiel de référence, et dans lequel une source de tension (UL) et sa résistance interne (RL) sont raccordées en parallèle à la deuxième capacité (CL), le noeud commun de l'électrode de source du premier transistor à effet de champ (P1) et de la première capacité (CH) étant raccordé au potentiel de référence par l'intermédiaire d'un circuit série constitué des sections d'un deuxième transistor à effet de champ (P2) et d'un troisième transistor à effet de champ (M1), **caractérisé en ce que** le noeud commun de l'électrode de drain du premier transistor à effet de champ (P1), de la deuxième capacité (CL) et de la source de tension (UL) est raccordée au potentiel de référence par l'intermédiaire d'un circuit série constitué par les sections d'un quatrième transistor à effet de champ (P3) et d'un cinquième transistor à effet de champ (M2), **en ce que** les électrodes de grille du premier, du quatrième et du cinquième transistor à effet de champ (P1, P3, M2) ainsi que le noeud commun du deuxième et du troisième transistor à effet de champ (P2, M1) sont reliés entre eux, **en ce que** le noeud commun du quatrième et du cinquième transistor à effet de champ (P3, M3) est relié à l'électrode de grille du deuxième transistor à effet de champ (P2) et est raccordé au potentiel de référence par l'intermédiaire de la section d'un sixième transistor à effet de champ (M3) et **en ce que** la sortie de commande de l'unité de commande (SE) est reliée à l'électrode de grille du troisième transistor à effet de champ (M1) et à l'entrée d'un inverseur (IN) dont la sortie est reliée à l'électrode de grille du sixième transistor à effet de champ (M3).

2. Agencement de circuit selon la revendication 1, **caractérisé en ce qu'**une résistance de protection (R) est placée entre le troisième transistor à effet de champ (M1) et le potentiel de référence.

3. Agencement de circuit selon la revendication 1 ou 2, **caractérisé en ce que** des transistors à effet de champ PMOS sont prévus pour le premier, le deuxième et le quatrième transistor à effet de champ (P1, P2, P3).

4. Agencement de circuit selon la revendication 1, 2 ou 3, **caractérisé en ce que** des transistors à effet de champ NMOS sont prévus pour le troisième, le cinquième et le sixième transistor à effet de champ (M1, M2, M3).
